(19) **Europäisches Patentamt / European Patent Office / Office européen des brevets**

(11) **EP 1 741 131 B1**

(12) **FASCICULE DE BREVET EUROPEEN**

(45) Date de publication et mention
de la délivrance du brevet:
**28.11.2007 Bulletin 2007/48**

(21) Numéro de dépôt: **05746639.3**

(22) Date de dépôt: **20.04.2005**

(51) Int Cl.:
***H01L 23/544*** (2006.01)

(86) Numéro de dépôt international:
**PCT/FR2005/050260**

(87) Numéro de publication internationale:
**WO 2005/106943 (10.11.2005 Gazette 2005/45)**

(54) **REALIGNEMENT ENTRE NIVEAUX APRES UNE ETAPE D'EPITAXIE**

EBENEN-NEUAUSRICHTUNG NACH EINEM EPITAXIESCHRITT

LEVEL REALIGNMENT FOLLOWING AN EPITAXY STEP

(84) Etats contractants désignés:
**DE GB IT**

(30) Priorité: **21.04.2004 FR 0450752**

(43) Date de publication de la demande:
**10.01.2007 Bulletin 2007/02**

(73) Titulaires:
- **COMMISSARIAT A L'ENERGIE ATOMIQUE
  75015 Paris (FR)**
- **Freescale Semiconductor, Inc.
  Austin, Texas 78735 (US)**

(72) Inventeurs:
- **DIEM, Bernard
  F-38130 ECHIROLLES (FR)**
- **BLANCHET, Eugène
  F-38120 SAINT EGREVE (FR)**
- **GOGOI, Bishnu
  SCOTTSDALE, Arizona 85259 (US)**

(74) Mandataire: **Poulin, Gérard
Société BREVATOME
3, rue du Docteur Lancereaux
75008 Paris (FR)**

(56) Documents cités:
**EP-A- 0 961 320          US-A- 4 936 930**

- **PATENT ABSTRACTS OF JAPAN vol. 1995, no. 09, 31 octobre 1995 (1995-10-31) -& JP 07 153669 A (NEC YAMAGATA LTD), 16 juin 1995 (1995-06-16)**
- **PATENT ABSTRACTS OF JAPAN vol. 012, no. 351 (E-660), 20 septembre 1988 (1988-09-20) & JP 63 108717 A (NEC CORP), 13 mai 1988 (1988-05-13)**
- **PATENT ABSTRACTS OF JAPAN vol. 1999, no. 02, 26 février 1999 (1999-02-26) -& JP 10 312964 A (SONY CORP), 24 novembre 1998 (1998-11-24)**
- **BLACK I: "ASM stepper alignment through thick expitaxial silicon films" PROCEEDINGS OF THE SPIE - THE INTERNATIONAL SOCIETY FOR OPTICAL ENGINEERING SPIE-INT. SOC. OPT. ENG USA, vol. 3741, mai 1999 (1999-05), pages 23-33, XP002319008 ISSN: 0277-786X**

EP 1 741 131 B1

## Description

### DOMAINE TECHNIQUE

L'invention se rapporte à un procédé permettant le réalignement entre niveaux après une étape d'épitaxie sur un substrat. L'invention se rapporte également à un substrat présentant au moins un repère permettant ce réalignement.

Elle concerne en particulier la réalisation d'épitaxies de matériau semiconducteur.

### ÉTAT DE LA TECHNIQUE ANTÉRIEURE

L'épitaxie est une croissance cristalline d'un matériau, réalisée en général sur le même matériau, avec respect de la maille et des orientations cristallines. Le réalignement entre niveaux après une étape d'épitaxie épaisse sur silicium est très important pour les applications en microélectronique et en microsystèmes. On a souvent besoin de réaliser sur le substrat silicium de base (substrat massif ou SOI) certaines opérations technologiques (appelées aussi niveaux photo-lithographiques) précédant une épitaxie épaisse. Ces niveaux sont alignés entre eux avec une grande précision (inférieure au micromètre) en raison des très faibles dimensions des motifs. Après une étape d'épitaxie épaisse (plusieurs dizaines de micromètres), il est nécessaire de poursuivre le processus technologique par des niveaux complémentaires qui doivent être parfaitement alignés sur les niveaux pré-épitaxie. Plus l'épitaxie est importante, plus ce réalignement est difficile.

Une des techniques connues de réalignement est d'utiliser des repères sur la face arrière du substrat, ces repères étant alignés avec les niveaux de la face avant (active) à l'aide d'un équipement spécifique (aligneur double face). L'épitaxie déposée sur la face avant ne détériorant pas ce repère, il peut être réutilisé comme référence pour les niveaux post-épitaxie.

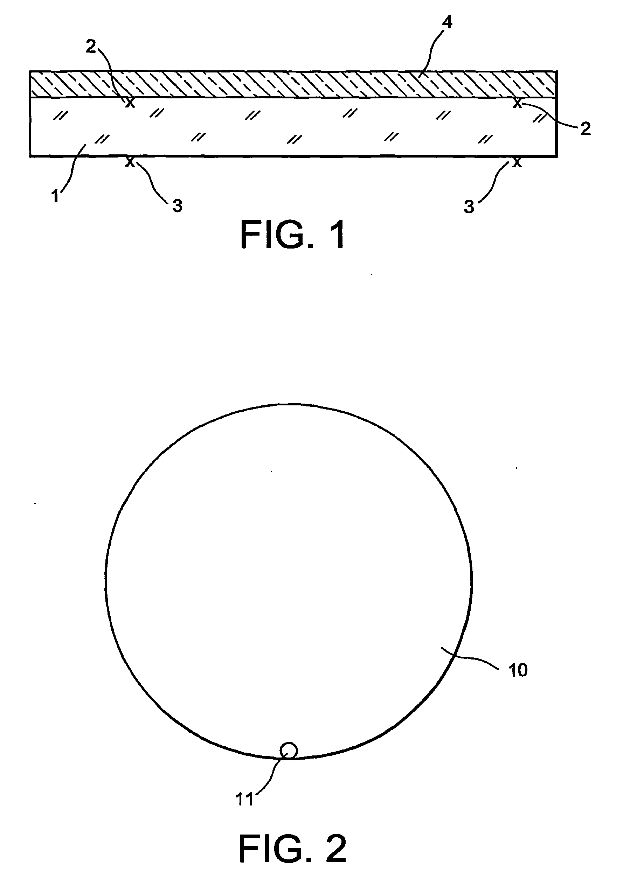

La figure 1 illustre cette technique. Il s'agit d'une vue en coupe transversale montrant un substrat semiconducteur 1 par exemple en silicium. Il peut s'agir d'un substrat massif ou d'un substrat SOI. Le substrat 1 est pourvu de repères 2 sur sa face avant (la face sur laquelle l'épitaxie est réalisée) et de repères 3 sur sa face arrière. La couche épitaxiée 4 dissimule les repères 2 de la face avant du substrat 1, qui ne sont donc plus d'aucune utilité. Par contre, les repères 3 sur la face arrière du substrat 1 peuvent encore être utilisés.

Les inconvénients principaux de cette technique sont :

- la nécessité d'utiliser un substrat poli sur la face arrière également (pour définir les repères) ce qui conduit à un substrat non standard donc plus cher.
- la nécessité d'utiliser un équipement spécifique pour créer ce repère face arrière et le relire après épitaxie.
- la précision d'alignement entre les repères face arrière et les niveaux face avant est limitée (quelques micromètres en général) et cette précision dépend de l'épaisseur du substrat.

Une seconde technique consiste à utiliser la fonction pré-alignement mécanique des équipements standard (appelés « steppers ») qui permet de positionner le substrat de façon relativement précise sans référence sur le substrat.

Cette seconde technique est illustrée par la figure 2 qui montre un substrat semiconducteur 10, vu de dessus. Le substrat 10 est pourvu d'un repère mécanique figuré en 11 sur la figure 2. ce repère mécanique peut être un méplat réalisé sur le côté du substrat ou une encoche. La précision de l'alignement obtenu reste néanmoins limitée à plusieurs micromètres dans les meilleurs cas.

Une autre technique, décrite par exemple dans la demande de brevet européen EP 0 961 320 A2, consiste à réaliser, sur la face avant du substrat, une marque ou repère dans le matériau du substrat (ou dans un matériau déposé sur ce substrat) qui, après la réalisation de l'épitaxie, sera transféré à la surface de la couche épitaxiée.

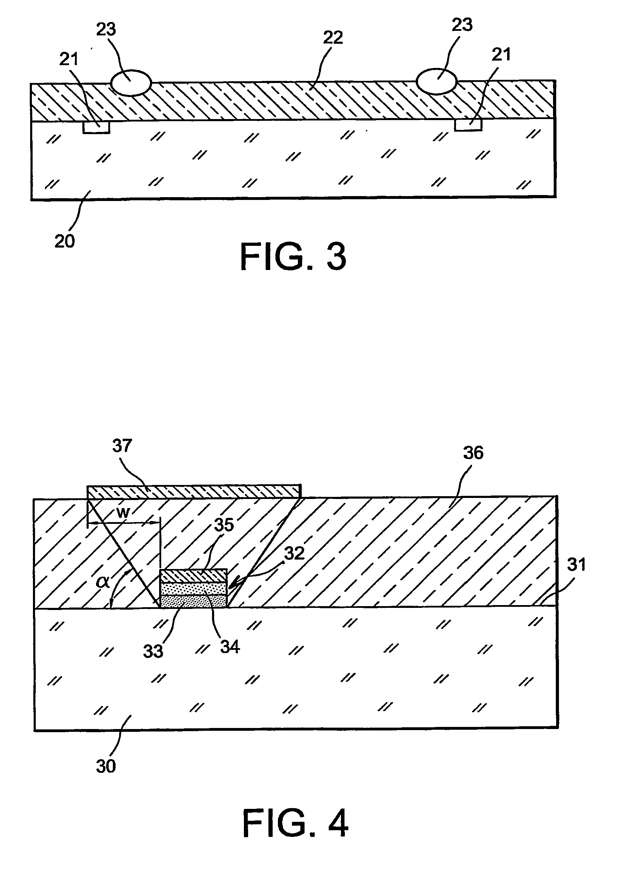

La figure 3 illustre cette technique. Il s'agit d'une vue en coupe transversale montrant un substrat semiconducteur 20, par exemple un substrat massif de silicium ou un substrat SOI. Des repères 21 ont été réalisés dans la couche supérieure du substrat 20. Ces repères sont constitués par exemple par la gravure d'une empreinte dans le substrat ou par la gravure d'une couche déposée sur ce substrat. Une couche 22 est déposée par épitaxie sur la face avant du substrat 20. L'épitaxie transfère les repères initiaux et la face avant de la couche épitaxiée 22 est alors pourvue de nouveaux repères 23. Cependant, ces repères 23 reproduits sont déformés et décalés par rapport aux repères initiaux 21 comme le montre la figure 3. Cette déformation et ce décalage rendent difficile une reconnaissance ultérieure et donc un alignement précis.

Le document JP 07 153 669 A décrit encore une autre technique de réalignement.

### EXPOSÉ DE L'INVENTION

Intrinsèquement, la technique de transfert d'une marque est la plus intéressante (équipement et substrat standard) et potentiellement la plus précise (travail sur la même face et reconnaissance optique).

La présente invention propose donc une technique de réalignement entre niveaux, utilisant un repère sur la face avant du substrat, ce repère étant après épitaxie reproduit avec une très bonne qualité et sans décalage.

L'invention a donc pour objet un procédé permettant le réalignement entre niveaux après une étape d'épitaxie sur une face d'un substrat, comprenant la réalisation d'au moins un repère initial sur ladite face du substrat, ce repère initial étant conçu pour être transféré, au cours de l'épitaxie, jusque sur la surface de la couche épitaxiée, le repère initial étant réalisé de manière que ses bords créent, durant l'épitaxie, des défauts de croissance qui se propagent jusque sur la surface de la couche épitaxiée pour fournir, sur la surface de la couche épitaxiée, un repère transféré reproduisant la forme du repère initial et en alignement avec le repère initial, le procédé étant caractérisé en ce que la réalisation du repère initial comprend la formation d'un plot comprenant un empilement d'au moins une couche de matériau ne permettant pas le développement de l'épitaxie, formée sur la face du substrat, et d'une couche d'un matériau permettant le développement de l'épitaxie. Ce plot peut être formé par des étapes de dépôt et de gravure de couches. La couche de matériau ne permettant pas le développement de l'épitaxie peut être une couche de matériau diélectrique.

Ladite face du substrat peut être une face permettant l'épitaxie d'un matériau semiconducteur. Elle peut aussi présenter un matériau semiconducteur.

Selon une application particulière, ladite face du substrat est en silicium monocristallin, la couche de matériau du repère initial permettant le développement de l'épitaxie étant en silicium polycristallin, les bords du repère étant alignés avec les axes cristallins du silicium monocristallin du substrat. La formation du plot peut alors comprendre, pour obtenir le matériau ne permettant pas le développement de l'épitaxie, la formation d'une couche d'oxyde de silicium et/ou la formation d'une couche de nitrure de silicium.

L'invention a aussi pour objet un substrat destiné à la réalisation d'une épitaxie sur l'une de ses faces, comprenant au moins un repère initial conçu pour obtenir, après l'étape d'épitaxie un repère transféré sur la surface de la couche épitaxiée, le repère initial présentant des bords aptes à créer, durant l'épitaxie, des défauts de croissance qui se propagent jusque sur la surface de la couche épitaxiée pour fournir, sur la surface de la couche épitaxiée, le repère transféré reproduisant la forme du repère initial et étant en alignement avec le repère initial, le substrat étant caractérisé en ce que le repère initial comprend un empilement comprenant au moins une couche de matériau ne permettant pas le développement de l'épitaxie, formée sur la face du substrat, et une couche d'un matériau permettant le développement de l'épitaxie.

**BRÈVE DESCRIPTION DES DESSINS**

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1, déjà décrite, est une vue en coupe transversale d'un substrat semiconducteur sur lequel une épitaxie a été réalisée, selon l'art antérieur,
- la figure 2, déjà décrite, est une vue de dessus d'un substrat semiconducteur pourvu d'un repère mécanique sur sa face avant, selon l'art antérieur,
- la figure 3, déjà décrite, est une vue en coupe transversale d'un substrat semiconducteur sur lequel une épitaxie a été réalisée, selon l'art antérieur,
- la figure 4 est une vue en coupe transversale d'un substrat semiconducteur sur lequel une épitaxie a été réalisée, selon l'invention,
- la figure 5 est une vue de dessus d'un substrat semiconducteur sur lequel une épitaxie a été réalisée, selon l'invention.

**DESCRIPTION D'UN MODE DE RÉALISATION PARTICULIER DE L'INVENTION**

La suite de la description portera, à titre d'exemple non limitatif, sur le cas d'un substrat offrant une face en silicium destinée à supporter une épitaxie de silicium.

La figure 4 est une vue en coupe transversale d'un substrat 30 présentant une face 31 en silicium sur laquelle une épitaxie doit être réalisée. Le substrat 30 peut être un substrat massif ou un substrat SOI.

Sur la face 31, au moins un repère initial 32 est réalisé. Ce repère initial est obtenu par dépôt et gravure d'un empilement de plusieurs couches. Ce repère permet de provoquer certains défauts durant l'épitaxie, ces défauts étant destinés à être transférés et visibles à la surface. L'empilement comprend successivement sur la face 31, après gravure, une couche d'oxyde de silicium 33, une couche 34 de nitrure de silicium et une couche 35 de silicium polycristallin. L'empilement peut ne comprendre qu'une seule couche de matériau diélectrique (en oxyde ou en nitrure). Les différentes couches peuvent avoir les épaisseurs suivantes : environ 100 nm pour l'oxyde de silicium, environ 500 nm pour le nitrure de silicium et environ 100 nm pour le silicium polycristallin.

Le silicium épitaxié 36 étant monocristallin, la géométrie du repère 32 est alignée avec les axes cristallographiques du silicium présenté par la face 31. A titre d'exemple, le repère 32 est aligné dans la direction <110> pour du silicium présenté par la face 31 d'orientation (100).

Durant l'épitaxie, les bords du repère vont créer des défauts de croissance qui se propagent selon le plan <111> jusqu'à la surface du matériau épitaxié. Ces plans sont inclinés d'un angle $\alpha$ valant 54,7° pour du silicium (100) et vont donc provoquer l'élargissement du repère initial 32 tout en restant parfaitement alignés avec celui-ci. Le motif final sera donc élargi sur chaque côté du repère initial d'une distance W telle que :

$$W = \frac{e}{tg\alpha}$$

e étant l'épaisseur de la couche épitaxiée.

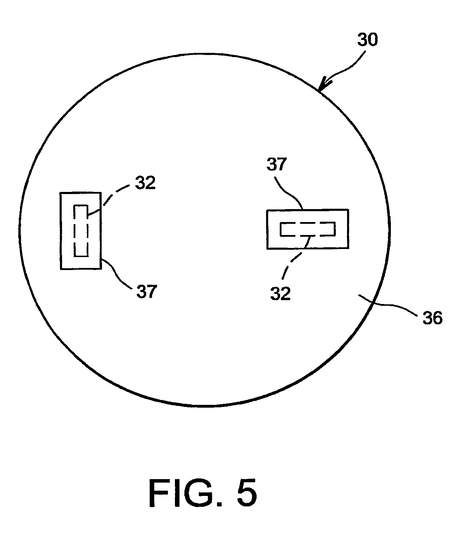

On obtient un repère transféré 37 dont la superficie est une reproduction agrandie de la superficie du repère initial 32. La figure 5 est une vue de dessus du substrat 30 sur lequel une épitaxie de silicium 36 a été réalisée. Elle montre deux directions possibles pour les repères.

Les inventeurs de la présente invention ont constaté que la couche de silicium polycristallin 35 du repère initial 32 permettait d'obtenir une épitaxie de bonne qualité au-dessus du repère avec une faible rugosité. Après l'étape d'épitaxie, le repère transféré 37 est de très bonne qualité et est très bien aligné et parfaitement lisible par les équipements standard de photolithographie (appelés « steppers » en anglais).

## Revendications

1.  Procédé permettant le réalignement entre niveaux après une étape d'épitaxie sur une face (31) d'un substrat (30), comprenant la réalisation d'au moins un repère initial (32) sur ladite face du substrat, ce repère initial étant conçu pour être transféré, au cours de l'épitaxie, jusque sur la surface de la couche épitaxiée, le repère initial (32) étant réalisé de manière que ses bords créent, durant l'épitaxie, des défauts de croissance qui se propagent jusque sur la surface de la couche épitaxiée (36) pour fournir, sur la surface de la couche épitaxiée, un repère transféré (37) reproduisant la forme du repère initial (32) et en alignement avec le repère initial, le procédé étant **caractérisé en ce que** la réalisation du repère initial (32) comprend la formation d'un plot comprenant un empilement d'au moins une couche de matériau (33, 34) ne permettant pas le développement de l'épitaxie, formée sur la face du substrat (30), et d'une couche d'un matériau (35) permettant le développement de l'épitaxie.

2.  Procédé selon la revendication 1, **caractérisé en ce que** le plot est formé par des étapes de dépôt et de gravure de couches.

3.  Procédé selon l'une des revendications 1 ou 2, **caractérisé en ce que** la couche de matériau (33, 34) ne permettant pas le développement de l'épitaxie est une couche de matériau diélectrique.

4.  Procédé selon l'une quelconque des revendications 1 à 3, **caractérisé en ce que** ladite face (31) du substrat (30) est une face permettant l'épitaxie d'un matériau semiconducteur (36).

5.  Procédé selon l'une quelconque des revendications 1 à 4, **caractérisé en ce que** ladite face (31) du substrat (30) présente un matériau semiconducteur.

6.  Procédé selon la revendication 3, **caractérisé en ce que** ladite face (31) du substrat (30) est en silicium monocristallin, la couche de matériau (35) du repère initial permettant le développement de l'épitaxie étant en silicium polycristallin, les bords du repère étant alignés avec les axes cristallins du silicium monocristallin du substrat.

7.  Procédé selon la revendication 6, **caractérisé en ce que** la formation du plot comprend, pour obtenir le matériau ne permettant pas le développement de l'épitaxie, la formation d'une couche (33) d'oxyde de silicium et/ou la formation d'une couche (34) de nitrure de silicium.

8.  Substrat destiné à la réalisation d'une épitaxie sur l'une de ses faces, comprenant au moins un repère initial (32) conçu pour obtenir, après l'étape d'épitaxie un repère transféré (37) sur la surface de la couche épitaxiée (36), le repère initial (32) présentant des bords aptes à créer, durant l'épitaxie, des défauts de croissance qui se propagent jusque sur la surface de la couche épitaxiée (36) pour fournir, sur la surface de la couche épitaxiée, le repère transféré (37) qui reproduit la forme du repère initial (32) et est en alignement avec le repère initial, **caractérisé en ce que** le repère initial (32) comprend un empilement comprenant au moins une couche de matériau (33, 34) ne permettant pas le développement de l'épitaxie, formée sur la face du substrat, et une couche d'un matériau (35) permettant le développement de l'épitaxie.

9.  Substrat selon la revendication 8, **caractérisé en ce que** la couche de matériau (33, 34) ne permettant pas le développement de l'épitaxie est une couche de matériau diélectrique.

10. Substrat selon l'une des revendications 8 ou 9, **caractérisé en ce que** ladite face (31) du substrat (30) est une face permettant l'épitaxie d'un matériau semiconducteur.

11. Substrat selon l'une quelconque des revendications 8 à 10, **caractérisé en ce que** ladite face (31) du substrat (30) présente un matériau semiconducteur.

12. Substrat selon la revendication 8, **caractérisé en ce que** ladite face (31) du substrat (30) est en silicium monocristallin, la couche de matériau (35) du repère initial (32) permettant le développement de l'épitaxie étant en silicium polycristallin, les bords du repère étant alignés avec les axes cristallins du silicium monocristallin du substrat.

13. Substrat selon la revendication 12, **caractérisé en ce que** la couche de matériau ne permettant pas le développement de l'épitaxie est une couche d'oxyde de silicium (33) ou une couche de nitrure de silicium (34).

## Claims

1.  Method enabling realignment between levels after a stage of epitaxy on a face (31) of a substrate (30), comprising the production of at least one initial guide mark (320 on said substrate face, this initial guide mark being designed so as to be transferred, during epitaxy, onto the surface of the epitaxied layer, the initial guide mark (32) being produced in such a manner that, during epitaxy, its edges create growth defects that propagate as far as the surface of the epitaxied layer (36) to provide a transferred guide mark (37) on the epitaxied layer (36) reproducing the shape of the initial guide mark (32) and in alignment with the initial guide mark, the method being **characterized in that** the production of the initial guide mark (32) includes the formation of a plate comprising a stack of at least one layer of material (33, 34) not allowing development of epitaxy, formed on the substrate face (30), and of a layer of material (35) permitting development of epitaxy.

2.  Method according to claim 1, **characterized in that** the plate is formed by stages of deposit and etching of layers.

3.  Method according to either one or the other of claims 1 or 2, **characterized in that** the layer of material (33, 34) not allowing development of epitaxy is a layer of dielectric material.

4.  Method according to any one of claims 1 to 3, **characterized in that** said face (31) of the substrate (30) is a face allowing epitaxy of a semiconductor material (36).

5.  Method according to any one of claims 1 to 4, **characterized in that** said face (31) of the substrate (30) is a semiconductor material.

6.  Method according to claim 3, **characterized in that** said face (31) of the substrate (30) is in monocrystalline silicon, the layer of material (35) of the initial guide mark allowing development of epitaxy being in polycrystalline silicon, the edges of the guide mark being aligned with the crystalline axes of the monocrystalline silicon of the substrate.

7.  Method according to claim 6, **characterized in that** the formation of the plate comprises, for obtaining the material not allowing development of epitaxy, the formation of a layer (33) of silicon oxide and/or the formation of a layer (34) of silicon nitride.

8.  Substrate intended for the production of an epitaxy on one of its faces, comprising at least one initial guide mark (32) designed to obtain, after the epitaxy stage, a transferred guide mark (37) on the surface of the epitaxied layer (36), the initial guide mark (32) having edges able to create growth defects during epitaxy, which propagate as far as the surface of the epitaxied layer (36) to provide, on the surface of the epitaxied layer, the transferred guide mark (37) that reproduces the shape of the initial guide mark (32) and is in alignment with the initial guide mark, **characterized in that** the initial guide mark (32) comprises a stack including at least one layer of material (33, 34) not allowing development of epitaxy, formed on the substrate face, and a layer of material (35) permitting development of epitaxy.

9.  Substrate according to claim 8, **characterized in that** the layer of material (33, 34) not allowing development of epitaxy is a layer of dielectric material.

10. Substrate according to any one of claims 8 to 9, **characterized in that** said face (31) of the substrate (30) is a face allowing epitaxy of a semiconductor material.

11. Substrate according to any one of claims 8 to 10, **characterized in that** said face (31) of the substrate (30) is a semiconductor material.

12. Substrate according to claim 8, **characterized in that** said face (31) of the substrate (30) is in monocrystalline silicon, the layer of material (35) of the initial guide mark (32) allowing the development of epitaxy being in polycrystalline silicon, the edges of the guide mark being aligned with the crystalline axes of the monocrystalline silicon of the substrate.

13. Substrate according to claim 12, **characterized in that** the layer of material not allowing development of epitaxy is a layer of silicon oxide (33) or a layer of silicon nitride (34).


## Patentansprüche

1.  Verfahren zur Ebenenneuausrichtung nach einem Epitaxieschritt auf einer Fläche (31) eines Substrats (30), das das Erzeugen wenigstens einer Ausgangsmarkierung (32) auf der Substratfläche umfaßt, wobei die Ausgangsmarkierung dazu ausgeführt ist, im Verlauf der Epitaxie bis zur Oberfläche der Epitaxieschicht übertragen zu werden und die Ausgangsmarkierung (32) auf eine solche Weise ausgeführt wird, daß ihre Ränder während der Epitaxie Aufwachsfehler erzeugen, die sich bis zu der Oberfläche der Epitaxieschicht (36) fortsetzen, um auf der Oberfläche der Epitaxieschicht eine übertragene Markierung (37) zu liefern, die die Form der Ausgangsmarkierung (32) wiedergibt und an der Ausgangsmarkierung ausgerichtet ist, wobei das Verfahren **dadurch gekennzeichnet ist, daß** die Erzeugung der Ausgangsmarkierung (32) die Bildung eines Elements umfaßt, das eine Aufschichtung aus mindestens einer auf der Substratfläche (30) gebildeten Schicht aus einem Material (33, 34), das das Epitaxiewachstum nicht erlaubt, und einer Schicht aus einem Material (35), das das Epitaxiewachstum erlaubt, umfaßt.

2. Verfahren gemäß Anspruch 1, **dadurch gekennzeichnet, daß** das Element durch Schritte einer Beschichtung und Ätzens von Schichten gebildet wird.

3. Verfahren gemäß einem der Ansprüche 1 oder 2, **dadurch gekennzeichnet, daß** die Schicht aus einem das Epitaxiewachstum nicht erlaubenden Material (33, 34) eine Schicht aus dielektrischem Material ist.

4. Verfahren gemäß einem der Ansprüche 1 bis 3, **dadurch gekennzeichnet, daß** die Fläche (31) des Elements (30) eine die Epitaxie eines Halbleitermaterials erlaubende Fläche (36) ist.

5. Verfahren gemäß einem der Ansprüche 1 bis 4, **dadurch gekennzeichnet, daß** die Fläche (31) des Substrats (30) ein Halbleitermaterial aufweist.

6. Verfahren gemäß Anspruch 3, **dadurch gekennzeichnet, daß** die Fläche (31) des Substrats (30) aus einem Siliziumeinkristall besteht, wobei die Schicht aus einem das Epitaxiewachstum nicht erlaubenden Material (35) der Ausgangsmarkierung aus einem Siliziumeinkristall besteht und die Ränder der Markierung an den Kristallachsen des Siliziumeinkristalls des Substrats ausgerichtet sind.

7. Verfahren gemäß Anspruch 6, **dadurch gekennzeichnet, daß** die Bildung des Elements zum Erhalten des das Epitaxiewachstum nicht erlaubenden Materials die Bildung einer Schicht aus Siliziumoxid (33) und/oder die Bildung einer Schicht aus Silziumnitrid (34) umfaßt.

8. Substrat zur Durchführung einer Epitaxie auf einer seiner Flächen, die wenigstens eine Ausgangsmarkierung (32) umfaßt, die zum Erhalten nach dem Epitaxieschritt einer übertragenen Markierung (37) auf der Oberfläche der Epitaxieschicht (36) ausgeführt ist, wobei die Ausgangsmarkierung (32) Ränder aufweist, die während der Epitaxie Aufwachsfehler erzeugen können, die sich bis zu der Oberfläche der Epitaxieschicht (36) fortsetzen, um auf der Oberfläche der Epitaxieschicht die übertragene Markierung (37) zu liefern, die die Form der Ausgangsmarkierung (32) wiedergibt und an der Ausgangsmarkierung ausgerichtet ist, **dadurch gekennzeichnet, daß** die Ausgangsmarkierung (32) eine Aufschichtung umfaßt, die mindestens eine Schicht aus einem Material (33, 34), das das Epitaxiewachstum nicht erlaubt, und eine Schicht aus einem Material (35), das das Epitaxiewachstum erlaubt, umfaßt.

9. Substrat gemäß Anspruch 8, **dadurch gekennzeichnet, daß** die Schicht aus dem das Epitaxiewachstum nicht erlaubenden Material (33, 34) eine Schicht aus dielektrischem Material ist.

10. Substrat gemäß einem der Ansprüche 8 und 9, **dadurch gekennzeichnet, daß** die Fläche (31) des Substrats (30) eine die Epitaxie eines Halbleitermaterials erlaubende Fläche ist.

11. Substrat gemäß einem der Ansprüche 8 bis 10, **dadurch gekennzeichnet, daß** die Fläche (31) des Substrats (30) ein Halbleitermaterial aufweist.

12. Substrat gemäß Anspruch 8, **dadurch gekennzeichnet, daß** die Fläche (31) des Substrats (30) aus einem Siliziumeinkristall besteht, wobei die Schicht aus dem das Epitaxiewachstum erlaubenden Material (35) der Ausgangsmarkierung (32) aus einem Siliziumeinkristall besteht und die Ränder der Markierung an den Kristallachsen des Siliziumeinkristalls des Substrats ausgerichtet sind.

13. Substrat gemäß Anspruch 12, **dadurch gekennzeichnet, daß** die Schicht aus dem das Epitaxiewachstum nicht erlaubenden Material eine Schicht aus Siliziumoxid (33) oder eine Schicht aus Silziumnitrid (34) ist.

**FIG. 1**

**FIG. 2**

FIG. 3

FIG. 4

FIG. 5

**EP 1 741 131 B1**

## RÉFÉRENCES CITÉES DANS LA DESCRIPTION

**Documents brevets cités dans la description**

- EP 0961320 A2

- JP 07153669 A